Europäisches Patentamt

European Patent Office

Office européen des brevets

(11) Publication number: **0 217 616**
**A2**

# EUROPEAN PATENT APPLICATION

(21) Application number: **86307273.2**

(22) Date of filing: **22.09.86**

(51) Int. Cl.⁴: **H 01 J 37/317**
**H 01 J 37/30**

(30) Priority: **23.09.85 GB 8523441**
**24.12.85 GB 8531723**

(43) Date of publication of application:
**08.04.87 Bulletin 87/15**

(84) Designated Contracting States:
**CH DE FR GB LI NL**

(71) Applicant: **VG INSTRUMENTS GROUP LIMITED**
**29 Brighton Road**
**Crawley West Sussex RH10 6AE (GB)**

(72) Inventor: **Stonestreet, Paul Richard**
**83 Farm Close**
**East Grinstead West Sussex (GB)**

**Moffatt, Stephen**
**75 Weymede**
**Byfleet Surrey KT14 7DH (GB)**

**Colling, John Anthony**
**Brambles**
**Buxted East Sussex (GB)**

(74) Representative: **Cockbain, Julian Roderick Michaelson et al**
**Frank B. Dehn & Co. European Patent Attorneys Imperial House 15-19, Kingsway**
**London WC2B 6UZ (GB)**

(54) Substrate processing apparatus.

(57) The invention provides a high-current, high-energy ion implantation apparatus suitable, for example, for the production of buried layers of oxygen or nitrogen ions in silicon wafers, and in which certain of the components which are subject to contact with the ion implanting ion beam are made substantially of silicon dioxide, preferably quartz or fused silica.

FIG.1.

**Description**

Substrate Processing Apparatus

This invention relates to apparatus for implanting ions into substrates, and especially to apparatus for implanting oxygen ions into silicon wafers.

The implantation of ions such as B+, P+, O+, N+, As+ or Sb+ into silicon wafer substrates is an important process used in the manufacture of certain semiconductor devices. In the process, a silicon wafer is bombarded by a beam of ions in an evacuated chamber so that atoms from the beam are deposited on the surface, or just beneath it, and modify the electrical characteristics of the wafer in a particular way. It has been found that bombardment of a silicon wafer with a high energy beam of oxygen ions causes a buried layer of silicon dioxide to be produced. Wafers treated in this way are thought to be useful for the fabrication of very large scale integrated circuits using what is known as "silicon-on-insulator" technology.

Up to now, the energy of the ion beams used to produce this buried oxide layer has been in the order of 200-400 keV, with beam currents up to 10mA. At least $2 \times 10^{18}$ atoms/cm$^2$ must be implanted however, and this can be achieved in approximately 10 minutes for a 100 mm diameter wafer and a beam current of 10 mA. However with this current density it is impossible to prevent the wafer overheating, and much lower current densities have to be employed. This is done by implanting a large number of wafers simultaneously, thereby reducing the average current density per wafer, but this results in a large increase in implantation time so that the cost of production of each chip using silicon-insulator technology is greatly increased. Consequently, attempts are currently being made to construct ion implanters which are capable of operation at 200-400 keV and 100-200 mA of beam current. With such apparatus, the required dose of $2 \times 10^{18}$ atoms/cm$^2$ can be imparted in less than 1 minute, so that the cost per chip is greatly reduced and the technology becomes economically attractive.

Difficult problems arise in the construction of these high power implanters in view of the very high power of the ion beam (of the order of 20-50 kW), as foreseen by R.F. Pinizzoto in a review of the subject published in Nucl. Instr. and Methods, 1985, vol. B7-8, part 1, pages 261-4. Not least amongst these problems is the effect of the high power beam on the structure of the implanter itself, and in particular on the structure which supports the wafers themselves, a structure which is of necessity exposed to the ion beam. In view of the shortness of the implantation time compared with the loading and pumpdown time of the implanter, it is necessary to batch process several hundred wafers simultaneously, so that the supporting structure may be quite extensive, often taking the form of a large rotating drum or disc to which the wafers are secured. Even in the case of existing medium current implanters (up to 10 mA beam current), special care has to be taken in the design of the wafer supports and in the choice of the materials used for parts of the implanter likely to contact the ion beam (see, for example, P.M. Rose, R. Fareta, and G. Ryding in Nucl. Instr. and Methods, 1985, vol. B6, page 27). Apart from physical damage being caused to these parts by the heat emitted when the ion beam strikes them, the main problems are the sputtering of ions from the structure of the implanter which may become implanted into the wafers, and the production of particulate contamination within the process chamber, typically by sputtering of the wafer supporting structure, or the flaking of material deposited on the implanter structure by previous contact with the ion beam. Inevitably, at lest some of this particulate contamination will be deposited on the surfaces of the wafers, reducing the yield of functional devices after the processing is completed. It is well known that the minimization of sputter and particle contamination is a very important aspect of semiconductor manufacturing processes, and the economic success of a production line may well be dependent on it. In the implanter decribed by Rose et al., the use of easily sputtered heavy metals such as Fe, Cr and Cu is avoided, and aluminium is used for all the critical components. R.G. Wilson, in Adv. in Electronics and Electron Phys., 1980, part 13B, page 45, has pointed out that the use of aluminium can cause a number of problems, and has suggested the use of silicon when silicon wafers are being implanted. This minimizes the damage to the wafer due to deposition of sputtered particles, but the construction of a large rotating supporting structure from silicon is impractical. It is also known to make parts of the implanter which are in close contact with the ion beam, especially defining slits and other electrodes, from graphite.

More recently, coatings of materials such as silicon carbide or silicon oxide (SiO) have been applied to the wafer supporting structure in order to reduce the effect of sputtering (see, for example, M. Guerra, V. Benveniste et al. in Nuclr. Instr. and Methods, 1985, vol. B6, page 63), but these coatings are prone to flaking which causes serious contamination of the process chamber. Frequent recoating of the surfaces is also necessary, resulting in increased downtime of the implanter.

It is an object of the present invention, therefore, to provide an apparatus for the treatment of substrates with an ion beam in which certain components liable to contact the ion beam are made of such material as to achieve reduced particulate contamination of the substrate during ion beam treatment thereof. It is a further object of the invention to provide such apparatus wherein the components in question are of a material which is not significantly damaged by contact with the ion beam and which apparatus is especially suitable for the implantation of oxygen ions into silicon substrates. It is a yet futher object of the invention to provide an ion implantation apparatus utilizing this material which produces reduced particulate contamination of the wafers being implanted, and which apparatus requires less maintenance than previously known implanters.

According to the invention therefore there is provided an apparatus for the treatment of substrates with an ion beam in an evacuated enclosure, said apparatus comprising components which are subject to contact with said ion beam, characterised in that at least one of said components is made substantially of silicon dioxide.

In preferred embodiments, the apparatus of the invention comprises first elements disposed to define an aperture through which said ion beam may pass and, optionally, second elements for defining said ion beam, said first and, when present, said second elements being made substantially from silicon dioxide. It will be appreciated that first elements may themselves serve to define the ion beam.

Preferably the silicon dioxide used in the apparatus of the invention is quartz, but fused silica is also suitable. In preferred embodiments the substrates are semiconducting silicon wafers, the apparatus preferably being provided with means for generating an ion beam comprising positive ions, especially preferably of oxygen or nitrogen.

By means of the use of silicon dioxide for fabricating components likely to contact the ion beam, the effect of sputtering causing particle contamination of the substrates is greatly reduced. The ions sputtered from quartz or fused silica will comprise only silicon or oxygen, the deposition of which on a silicon wafer in the presence of a powerful beam of oxygen ions is of little consequence. During the implantation of oxygen to produce a buried oxide layer, some oxygen contamination of the surface also occurs, but it is known to remove this oxide contamination by a light etching process after implantation, so that any additional contamination by oxygen due to the sputtering of the silicon dioxide is relatively unimportant. In contrast, the deposition of sputtered metal is more serious, because metal atoms diffuse more deeply into the silicon substrate and cannot easily be removed by etching. Further, the use of quartz or fused silica for beam and aperture defining components minimizes the contamination of the beam itself by ions other than silicon and oxygen. Other properties of quartz or fused silica which are advantageous in the environment of a high power ion implanter include their low coefficients of thermal expansion, their high melting points, and their very low sputter rates. It is also relatively easy to fabricate a wafer supporting means from quartz or fused silica because they are easily available in plate form and have adequate mechanical strength. These properties make them additionally suitable for use in implanters using beams of ions other than oxygen and with substrates other than silicon.

It would have been thought by those skilled in the art that the use of an electrical insulator such as quartz for components which are struck by the ion beam would not be successful because the insulator will become charged to a high potential by contact with the ion beam, which potential will then cause the ion beam to be deflected or otherwise affected in an unpredictable and undesirable way. This would be thought to be especially true of components such as those providing beam defining or focussing slits. The inventors have found, however, that in practice the effects of charging are not as severe as would have been expected, and what effects are observed can be eliminated by careful design. The reason for this is not fully understood, but it appears that there exist natural mechanisms which counteract the charging effect of the bombardment of the ion beam, for example, at least in the relevant energy range the loss of charge through the emission of secondary charged particles approximately compensates the gain in charge from the impact of the ion beam. Presumably also the charge built up on the surface of the quartz tends to be further reduced by electrical leakage which is known to be considerably higher at a typical implant temperature of 500°-700°C than at 20°C. However, it is also within the scope of the invention to substantially neutralize any charge build-up which does occur on the surfaces of critical silicon dioxide components by means of a beam of electrons from a gun or heated filament, etc., positioned to bombard the affected surface. The intensity of the beam of electrons is then adjusted to just neutralise any build-up of positive charge. This refinement is not always necessary, however and it is in general preferable to rely on electrical leakage preventing an excessive build-up of charge. This process can be encouraged by careful design of the components likely to be affected, so that in preferred embodiments of the apparatus of the invention at least one of the components made substantially from silicon dioxide has provided on a surface thereof at least one electrical conductor means which is capable of being maintained at a fixed electrical potential and which is so disposed that the ion beam does not impinge directly on it. The build-up of the electrical charge on at least some of the surfaces of the silicon dioxide components is thus minimized by the provision of these electrical conductors which while close to surfaces are shielded from direct contact with the ion beam. Preferably the conductors, which conveniently are metallic, are disposed in grooves in the surface of the relevant silicon dioxide component(s) in such a way that the ion beam does not impinge directly on them, thereby minimizing the sputtering of metallic ions. In this way the distance between the surface contacted by the ion beam and a conductor maintained at a fixed potential may be minimized so that leakage of any unwanted electrical charge is maximized. Especially when the components operate at high temperature, this technique usually reduces the accumulation of charge to unobjectionable levels.

The apparatus of the invention is preferably arranged for the treatment of substrates comprising semi-conductor wafers, and preferably comprises a rotatably mounted drum having an inner surface on at least part of which, during operation, the ion beam impinges. In one preferred embodiment, that inner surface comprises a plurality of wafer holding plates made substantially of silicon dioxide on which the said wafers may be mounted, the plates being disposed so that the plates are the only parts of the inner surface of the drum on which the ion beam impinges; thus the ion beam entering the wafer-loaded drum impinges only on the plates and on the wafers mounted on them.

The wafers may be supported from the wafer holding plates by attachment means which are themselves preferably fabricated from silicon dioxide.

In this way only the wafer substrates and the silicon dioxide plates and attachment means are struck by the ion beam. Preferably the holding plates comprise flat rectangular plates fitted in overlapping fashion around the inside of the drum in the shape of a polygonal prism. The drum is preferably in the form of a truncated cone. Both the wafer holding plates and the drum conveniently should contain at least one hole behind each of the wafers so that efficient transfer of heat can take place between the wafers and a stationary surface surrounding the drum which is maintained at a fixed temperature. In this way the temperature of the wafers during implantation can be controlled. Alternatively, if the material used for the wafer holding plate has a relatively high transparency in the infra-red region, sufficient thermal contact with the stationary surface may be obtained by radiation through the plates, and the holes can be omitted.

It is not usually necessary to ensure good thermal contact between the wafer and its supports (i.e. the attachment means or the holding plates), because, in preferred forms of the apparatus of the invention, temperature control is effected by a radiative mechanism, as explained. Consequently, simple attachment means capable of loosely retaining a wafer in position during the loading and unloading processes will suffice, because the centrifugal force due to the rotation of the drum will hold the wafers in fixed positions during implantation. Simple devices, easily fabricated from quartz or fused silica, will suffice, for example a bracket fused to the holding plate below each wafer, preferably containing a slot to receive the wafer, would be suitable. Alternatively, at least two slotted peg-like supporting members disposed below the wafer and at least one stop member disposed behind the upper part of the wafer may be provided. The slots in the supporting members conveniently are adapted to receive the edge of the wafer which they are to support. Such an arrangement is described in detail in our copending patent application, UK application number 8531723, a copy of which has been placed on the file of the present application.

In an alternative embodiment, the apparatus of the invention, arranged for the treatment of semi-conductor wafers, comprises a rotatably mounted drum having an inner surface on at least a part of which, during operation, the ion beam impinges, and attachment means made substantially of silicon dioxide for securing the wafers to the inner surface.

The attachment means may conveniently comprise slotted brackets or pegs as described previously, and may be mounted directly on the inner surface of the drum or on wafer holding plates disposed inside the drum. In the latter case, the plates may be made of metal coated with silicon or silicon oxide in a known manner. It will be appreciated that the attachment means are the components of the apparatus which are closest to the wafers and are therefore the most critical components as regards wafer contamination by sputtering during implantation. Therefore in certain applications it may be sufficient to provide only silicon dioxide attachment means and to use coated conventional metal holding plates in order to achieve the advantages of the invention.

Although radiation cooling is the preferred method of maintaining the wafers at the desired temperature, it is also within the scope of the invention to provide the apparatus with cooling means for the water cooling of the holding plates and wafers.

A preferred embodiment of the apparatus of the invention will now be described in greater detail with reference to the accompanying drawings, in which:-

Figure 1 is a vertical cross-section of the implantation chamber of an apparatus constructed in accordance with the invention;

Figure 2 is a horizontal cross-section showing part of the inner surface of a rotating drum for the apparatus of Figure 1 to which wafer substrates are attached during implantation;

Figure 3 illustrates means for reducing build-up of electrical charge on certain components of the apparatus of Figure 1;

Figure 4 illustrates alternative means for reducing charge build-up on certain components of the apparatus of Figure 1; and

Figure 5 is a side elevation of a wafer support means by which wafers to be implanted may be supported inside the rotating drum of the apparatus of Figure 2.

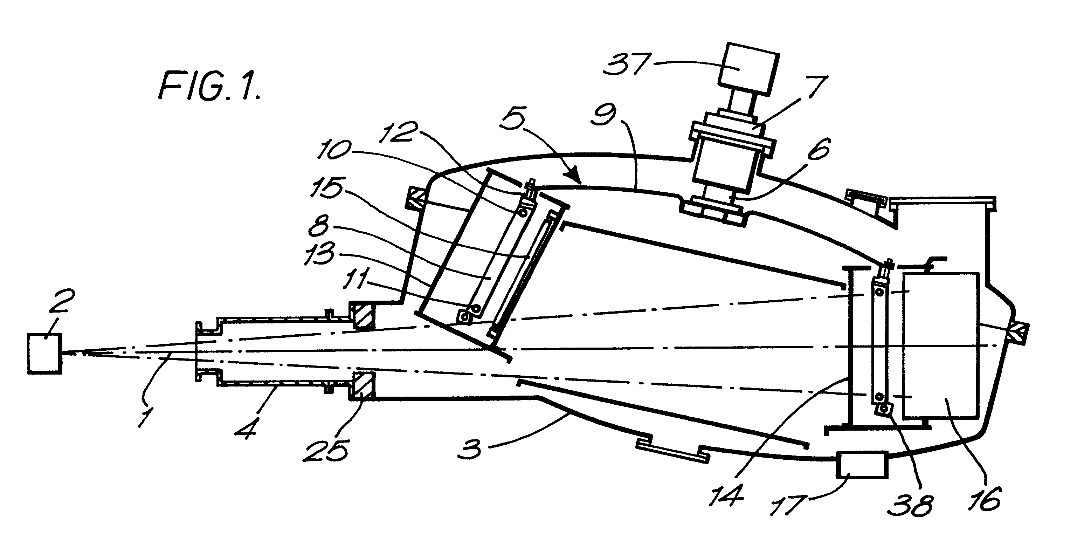

Referring first to Figure 1, an ion beam 1 from an ion source 2 passes into an evacuated implantation vessel 3 through an aperture 25 and an adaptor 4. Ion beam 1 typically comprises a beam of oxygen ions, accelerated to 200 keV and up to 200 mA current. Preferably a mass filter is incorporated in the ion source to remove ions of unwanted mass-to-charge ratios. A drum 5 is mounted on shaft 6 which rotates in bearing 7 which incorporates a rotary vacuum seal to prevent the ingress of air around shaft 6. Shaft 6 is driven by motor 37, typically at 120 r.p.m. Drum 5 comprises a solid upper surface 9 and a plurality of struts 8 which form its sides, and is in the form of a truncated cone. Struts 8 are mounted from upper surface 9 and are linked to a circular structural member 38 at their lower ends. The angle of shaft 6 to the vertical, and the upper and lower diameter of drum 5 are selected so that struts 8 are substantially perpendicular to the axis of ion beam 1 at the side of the drum remote from adaptor 4 as shown in figure 1. Both surface 9 and member 38 are cooled by water introduced through pipes 12 via rotary feedthroughs incorporated in bearing 7. In order to minimize stress, and the consequent distortion of the drum, the conduction of heat between the struts 8, surface 9 and member 33 is minimized by the provision of holes 10 and 11 close to the ends of each of struts 8. This allows the temperature of struts 8 to rise several hundred °C without damage to the drum. Because of their high operating temperature, struts 8 are conveniently made from stainless steel. A water cooled surface 13, in the form of a stationary truncated cone, surrounds the outer surface of drum 5, and has a large surface area directly exposed to the rear of wafers undergoing implantation which are mounted on the inside surface of drum 5. A second cooled surface 14 is also provided on the inside of drum 5. Heat is effectively transferred from the wafers to surfaces 13 and 14 by radiation, and this transfer is arranged so that the wafers are maintained at a temperature lower than the optimum with the ion beam operating at the desired power. Heaters 15, mounted on surface 14, are used to supply additional heat to raise the temperature to the value required, and the temperature is maintained at the required value by regulating the power to heaters 15. A conventional radiation pyrometer may be used to monitor the temperature of the wafers. Surfaces 13 and 14 contain apertures to allow the beam to pass through to the interior of drum 5 without obstruction. One or more slots are typically provided in drum 5 to allow the beam to pass through into cooled beam dump 16 when the slot is suitably positioned. Dump 16 is preferably a Faraday cup in order that the intensity of the beam striking it may be accurately measured.

Wafers are loaded on to the inner surface of drum 5 though access port 17, preferably by means of an automatic loading apparatus. Drum 5 is capable of carrying a large number of wafers in order that wafers may be implanted economically, and is typically 1500 mm diameter.

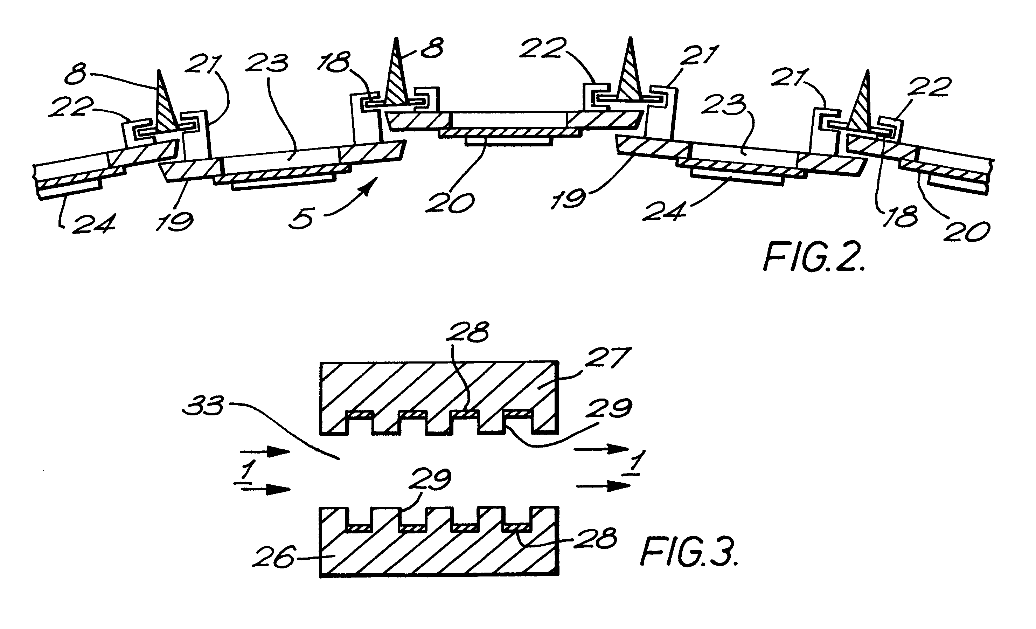

Referring next to Figure 2, struts 8, viewed in cross section and typically of stainless steel, carry lugs 18 which are attached by welding. Alternate wafer holding plates 19, each comprising a flat quartz plate, have respectively long mounting posts 21 and short mounting posts 22, also of quartz, fused to them. Posts 21 and 22 contain slots into which lugs 18 locate. Plates 19, fitted alternately with long and short posts, are mounted around the inner surface of drum 5 so that they overlap at the joints as shown. A continuous surface of quartz is therefore presented to ion beam 1 as drum 5 rotates. Some of plates 19 may comprise slots (not shown) through which beam 1 may pass into beam dump 16 when the drum is correctly positioned. Wafers 20 are secured to plates 19 by virtue of centrifugal force during implantation, but are retained in approximate location when the drum is stationary by brackets 24 fused to plates 19 below each wafer. Preferably brackets 24 are quartz and contain a slot into which the edge of the wafers fit loosely. Alternatively, as shown in figure 5, the wafers 20 may be supported from the plates 19 by at least two peg-like members 34 which contain slots 35 adapted to receive the edge of wafer 20. One or more stop members 36 is also provided, as shown in figure 5. Peg-like members 34 and stop members 36 are preferably made of quartz or fused silica. Plates 19 may be provided as shown in figure 2 with holes 23 behind each wafer to facilitate the transfer of heat by radiation from the wafer to cooled cooled surface 13. The lower edges of plates 19 may be supported by stops attached to struts 8 which can be removed to allow the plates to be changed.

The type of quartz used for plates 19, brackets 24 or members 34 and 36 is not critical. and a poor optical quality will suffice. Preferably it should be as pure as possible to prevent sputtering of unwanted materials. A BQ or BQE grade, available from Heraeus GmbH, is particularly suitable.

Figure 3 illustrates a method by which the charging of surfaces with the ion beam may be minimized. An aperture 33 through which the ion beam 1 passes comprises two silicon dioxide elements 26 and 27, preferably quartz or fused silica. Several grooves 29 are cut in the surfaces of elements 26 and 27 in such a way that the ion beam 1 does not impinge on the bottom surfaces of the grooves. At the bottom of each groove a metallic conductor 28 is fitted. These conductors are connected to a fixed electrical potential, usually earth. In this arrangement, the distance from the points of contact with the ion beam to a point of fixed potential is minimized so that electrical leakage is increased and the build-up of an unwanted potential on the surface is greatly reduced. Ion beam 1 does not impinge directly on the conductors 28, so that contamination of the beam with metal ions is prevented. Apertures constructed in this way may be used in a variety of locations, for example at 25 (figure 1).

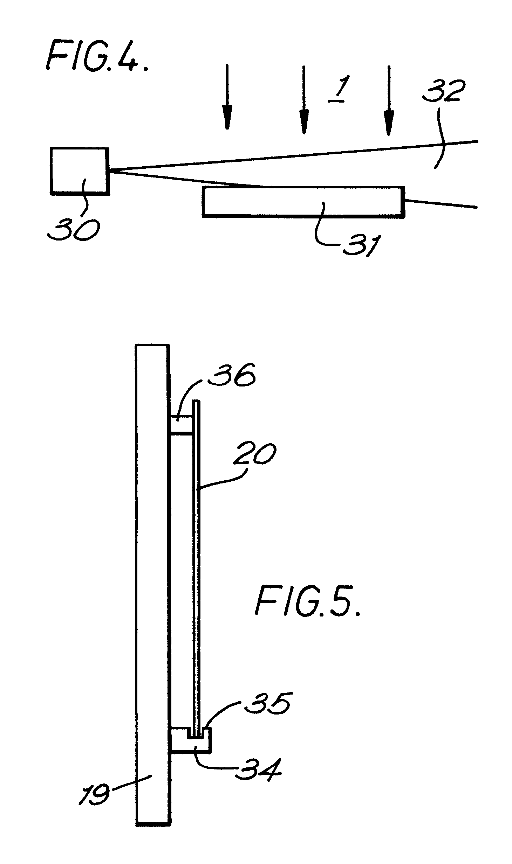

Figure 4 shows how an electron flood gun can be used to minimize charge build-up on quartz surfaces within the implanter apparatus. Where a quartz member 31 (which may be a wafer holding plate 19, for example) is unavoidably positioned in the path of at least a portion of the ion beam 1 charge build-up on the surface of member 31 is neutralised by a beam of electrons 32 from a gun 30. A suitable method is described in detail in US patent No. 3,507,709.

## Claims

1. An apparatus for the treatment of substrates (20) with an ion beam (1) in an evacuated enclosure (3), said apparatus comprising components (25, 19, 34) which are subject to contact with said ion beam, characterized in that at least one of said components is made substantially from silicon dioxide.

2. An apparatus as claimed in claim 1 comprising at least one element (25) made substantially from silicon dioxide and disposed to define an aperture through which said ion beam (1) may pass.

3. An apparatus as claimed in claim 2 wherein at least one said element (25) is disposed to define said ion beam (1).

4. An apparatus as claimed in any one of claims 1 to 3 arranged for the treatment of substrates comprising semiconducting wafers (20), said apparatus further comprising a rotatably mounted drum (5) having an inner surface on at least a part of which said ion beam (1) impinges, said inner surface comprising a plurality of wafer holding plates (19) made substantially of silicon dioxide onto which said wafers may be mounted, said plates being disposed so that said part of said inner surface on which said ion beam impinges is comprised of said plates.

5. An apparatus as claimed in claim 4 wherein said wafer holding plates (19) are provided with attachment means (24) made substantially of silicon dioxide whereby to secure said wafers to said plates.

6. An apparatus as claimed in any one of claims 1 to 3 arranged for the treatment of substrates comprising semiconducting wafers (20), said apparatus further comprising a rotatably mounted drum (5) having an inner surface on at least a part of which said ion beam (1) impinges, and attachment means (34) made substantially of silicon dioxide for securing said wafers to said inner surface.

7. An apparatus as claimed in claim 6 wherein said inner surface comprises a plurality of wafer holding plates (19) made substantially of metal and on which said attachment means (34) are mounted.

8. An apparatus as claimed in any one of claims 5 to 7 wherein said attachment means for each said wafer (20) comprise at least two peg-like supporting members (34) arranged to be disposed below said wafer and disposed above said supporting members at least one stop member (34) arranged to be disposed behind said wafer, said supporting members comprising slots (35) arranged to receive the edge of said wafer.

9. An apparatus as claimed in any one of claims 1 to 8 wherein said silicon dioxide comprises quartz.

10. An apparatus as claimed in any of claims 1 to 8 wherein said silicon dioxide comprises fused silica.

11. An apparatus as claimed in any one of claims 1 to 10 wherein at least one of said components (26, 27) made substantially from silicon dioxide is provided in a surface thereof with at least one electrical conductor means (28) which is capable of being maintained at a fixed electrical potential and which is so disposed that said ion beam (1) does not impinge directly thereon.

12. An apparatus as claimed in claim 11 wherein said conductor means (28) is disposed in a groove (29) in an ion beam exposed surface of said component (26, 27).

13. An apparatus as claimed in any one of claims 1 to 12 further comprising (a) means (2) for generating a said ion beam (1) comprising positive ions; and (b) means (30) for generating an electron beam incident on the ion beam exposed surface of a said component (31) made substantially from silicon dioxide whereby to reduce substantially the build-up of positive charge on said ion beam exposed surface due to said ion beam (1) impinging thereon.

FIG.1.

FIG.2.

FIG.3.

*FIG.4.*

*1*

*32*

*30*

*31*

*36*

*20*

*FIG.5.*

*35*

*34*

*19*